# EUROPEAN PATENT APPLICATION

(11) **EP 3 699 613 A1**
(43) Date of publication of application: **26.08.2020**
(21) Application number: 18869061.4
(22) Date of filing: 06.07.2018
(51) Int. Cl.: G01R 29/24, G01N 27/30, G01N 27/416

(54) **CHARGE DETECTION SENSOR AND POTENTIAL MEASURING SYSTEM**

(30) Priority: 18.10.2017 JP 2017201458
(71) Applicant: Sony Semiconductor Solutions Corporation, Atsugi-shi, Kanagawa 243-0014 (JP)
(72) Inventor: SHIMIZU, Kan, Atsugi-shi, Kanagawa 243-0014 (JP)
(74) Representative: Müller Hoffmann & Partner
(86) International application number: PCT/JP2018/025666
(87) International publication number: WO 2019/077814

(57) **Abstract**

Provided is an electric charge detection sensor that has a plurality of electrodes arranged in an array and detects electric charge generated in solution on each electrode, in which a sensing sensitivity is improved.

The electric charge detection sensor includes a plurality of detection electrodes that is arranged in an array and detects electric charge. The plurality of detection electrodes is insulated from each other by an insulating portion. A group of conductive particles is deposited on surfaces of the plurality of detection electrodes. This allows for formation of a three-dimensional electrode on the surface of each detection electrode, an increase in surface area of each detection electrode, and a reduction in resistance.

## Description

### TECHNICAL FIELD

The present technology relates to an electric charge detection sensor. Specifically, the present technology relates to an electric charge detection sensor and a potential measurement system using the electric charge detection sensor.

### BACKGROUND ART

Electric charge detection sensors that have a plurality of electrodes arranged in an array and detect electric charge generated in solution on each electrode have conventionally attracted attention. For example, a potential measuring device that measures a potential at an action potential generation point generated due to a chemical change has been proposed (see, for example, Patent Document 1).

### CITATION LIST

### PATENT DOCUMENT

Patent Document 1: WO 2017/061171 A

### SUMMARY OF THE INVENTION

### PROBLEMS TO BE SOLVED BY THE INVENTION

In the above-described conventional technology, electrodes arranged in an array are soaked in solution, and electric charge generated in the solution is detected. In order to improve a sensing sensitivity in the above-described electric charge detection sensors, it is conceivable to increase the area for sensing. However, increasing the areas of the electrodes themselves causes the area of the entire device to increase and makes downsizing difficult.

The present technology has been developed in view of such a situation, and is aimed at improving a sensing sensitivity in an electric charge detection sensor.

### SOLUTIONS TO PROBLEMS

The present technology has been made to solve the above-described problems. A first aspect of the present technology is an electric charge detection sensor including a plurality of detection electrodes that is arranged in an array and detects electric charge, an insulating portion that insulates the plurality of detection electrodes from each other, and a group of conductive particles deposited on surfaces of the plurality of detection electrodes. This brings about an effect of increasing the surface area of each detection electrode and reducing a resistance, thereby improving the sensing sensitivity.

Furthermore, in the first aspect, the group of particles may be a group of nanoparticles each having a size on the order of nanometers. More specifically, the group of particles may be a group of platinum nanoparticles. This brings about an effect of three-dimensionally depositing a group of nanoparticles on the surface of each detection electrode, thereby increasing the surface area.

Furthermore, in the first aspect, the plurality of detection electrodes may be water-insoluble electrodes using metal as a material. More specifically, the plurality of detection electrodes may be electrodes using platinum as a material. This brings about an effect of encasing the electric charge detection sensor with a metal material when the group of nanoparticles is deposited.

Furthermore, in the first aspect, the insulating portion may have a protruding shape at a portion away from the surface of each detection electrode by a predetermined distance. This brings about an effect of preventing a conductive film from being formed on side walls of an insulation layer.

Furthermore, in the first aspect, the protruding shape of the insulating portion is preferably disposed at a position higher than the height of the group of particles. Furthermore, the protruding shape of the insulating portion preferably has a protrusion longer than the height of the group of particles. This ensures the effect of preventing a conductive film from being formed on the side walls of the insulation layer.

Furthermore, in the first aspect, the protruding shape of the insulating portion may be formed by using a material different from the material of other portions of the insulating portion. This brings about an effect of facilitating formation of a protruding shape on an insulation layer.

Furthermore, in the first aspect, each of the plurality of detection electrodes may include a recess for connection with a wiring layer. This brings about an effect of allowing each detection electrode to be connected to a wiring layer.

Furthermore, in the first aspect, a contact may be further included to allow each of the plurality of detection electrodes to be connected to the wiring layer. The contact may be a metal-embedded plug-type contact or a through silicon via type contact. This brings about an effect of allowing each detection electrode to be connected to the wiring layer by using the contact.

Furthermore, in the first aspect, the electric charge detection sensor may detect ions in solution that is in contact with each detection electrode.

Furthermore, in the first aspect, the electric charge detection sensor may be a biosensor that detects the electric charge to measure a biological activity or identify a biological substance.

Furthermore, a second aspect of the present technology may be a potential measurement system including: an electric charge detection sensor that includes a plurality of detection electrodes that is arranged in an array and detects electric charge, an insulating portion that insulates the plurality of detection electrodes from each other, and a group of conductive particles deposited on surfaces of the plurality of detection electrodes, and performs potential measurement; a control unit that controls potential measurement in the electric charge detection sensor; a measurement result processing unit that processes a result of measurement by the electric charge detection sensor; and a display unit that displays the processed measurement result. This brings about an effect of processing the result of measurement by the electric charge detection sensor and displaying the result as an image or a moving image.

### EFFECTS OF THE INVENTION

The present technology can produce an excellent effect of improving the sensing sensitivity in the electric charge detection sensor. Note that the effects described here are not necessarily restrictive, and the effects of the invention may be any of the effects described in the present disclosure.

### BRIEF DESCRIPTION OF DRAWINGS

Fig. 1 illustrates an example of an external appearance of an electric charge detection sensor 10 as viewed from above according to an embodiment of the present technology.
Fig. 2 illustrates an example of an external appearance of a cell 12 as viewed from above according to the embodiment of the present technology.
Fig. 3 illustrates an example of a sectional view of the electric charge detection sensor 10 as viewed from above according to the first embodiment of the present technology.
Fig. 4 illustrates an example of a sectional view of a detection electrode 130 according to the embodiment of the present technology.
Fig. 5 illustrates a first example of a shape of an insulation layer 140 according to the first embodiment of the present technology.
Fig. 6 illustrates a second example of a shape of the insulation layer 140 according to the first embodiment of the present technology.
Fig. 7 illustrates a third example of a shape of the insulation layer 140 according to the first embodiment of the present technology.
Fig. 8 illustrates an example of a sectional view of an electric charge detection sensor 10 according to a modified example of the first embodiment of the present technology.
Fig. 9 illustrates an example of a sectional view of an electric charge detection sensor 10 according to a second embodiment of the present technology.
Fig. 10 illustrates an example of a cross-sectional shape of a side wall portion of an insulation layer 140 according to the second embodiment of the present technology.
Fig. 11 illustrates an example of a shape of the insulation layer 140 according to the second embodiment of the present technology.
Fig. 12 illustrates an example of a sectional view of the electric charge detection sensor 10 according to a modified example of the second embodiment of the present technology.
Fig. 13 illustrates a configuration example of a potential measurement system according to a third embodiment of the present technology.

### MODE FOR CARRYING OUT THE INVENTION

Modes for carrying out the present technology (hereinafter referred to as "embodiments") will be described below. The description will be made in the following order.
1. First embodiment (example in which platinum nanoparticles are used to form a three-dimensional electrode)
2. Second embodiment (example in which side walls of an insulating portion between electrodes have an eaves shape)
3. Third embodiment (example of application to a potential measurement system)

### <1. First embodiment>

### [Electric charge detection sensor]

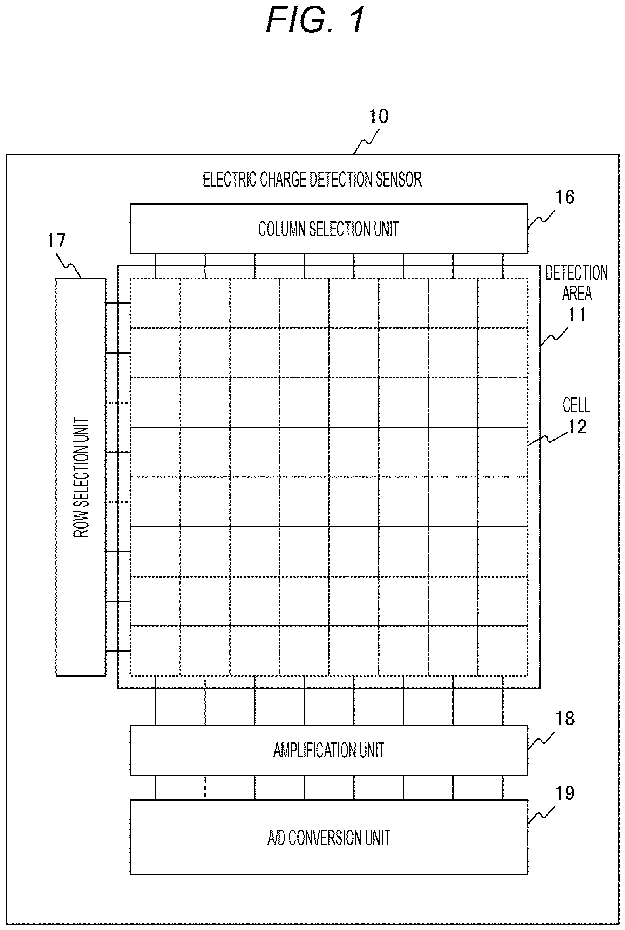

Fig. 1 illustrates an example of an external appearance of an electric charge detection sensor 10 as viewed from above according to an embodiment of the present technology.

The electric charge detection sensor 10 is a sensor that detects electric charge in solution. A detection area 11 is disposed on the upper surface of the electric charge detection sensor 10, and solution serving as a sample is soaked in the detection area 11. Furthermore, the electric charge detection sensor 10 includes a column selection unit 16, a row selection unit 17, an amplification unit 18, and an A/D conversion unit 19.

The detection area 11 has a plurality of cells 12 each including a detection element, and the plurality of cells 12 is arranged in a two-dimensional array to form an element array. Each of the plurality of cells 12 detects electric charge. Note that this example shows an 8x8 element array, but this is only an example and an element array can have any size as necessary.

The column selection unit 16 outputs a column selection signal for selecting a column of cells 12 in the two-dimensional array in the detection area 11. The row selection unit 17 outputs a row selection signal for selecting a row of cells 12 in the two-dimensional array in the detection area 11. The column selection unit 16 and the row selection unit 17 select identify one of the cells 12 in the two-dimensional array.

The amplification unit 18 amplifies a potential signal from the cell 12 selected by the column selection unit 16 and the row selection unit 17.

The A/D conversion unit 19 converts the potential signal amplified by the amplification unit 18 from an analog value to a digital value.

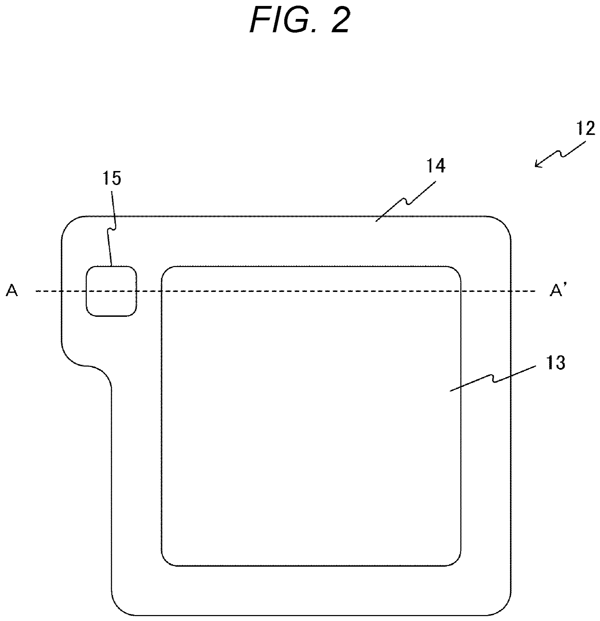

Fig. 2 illustrates an example of an external appearance of a cell 12 as viewed from above according to the embodiment of the present technology.

The cell 12 includes a detection unit 13 that detects electric charge, and is surrounded by an insulating portion 14 that insulates the cell 12 from other cells 12. The solution soaked in the detection area 11 is in contact with the detection unit 13. This allows each of the plurality of cells 12 to detect electric charge of ions in the solution that is in contact with the detection unit 13.

Note that each cell 12 may have a recess 15 in a part of the insulating portion 14. This is just an example for connecting the detection unit 13 to a wiring under the detection unit 13 as described later, and various other techniques can be conceived to achieve the connection.

### [Structure]

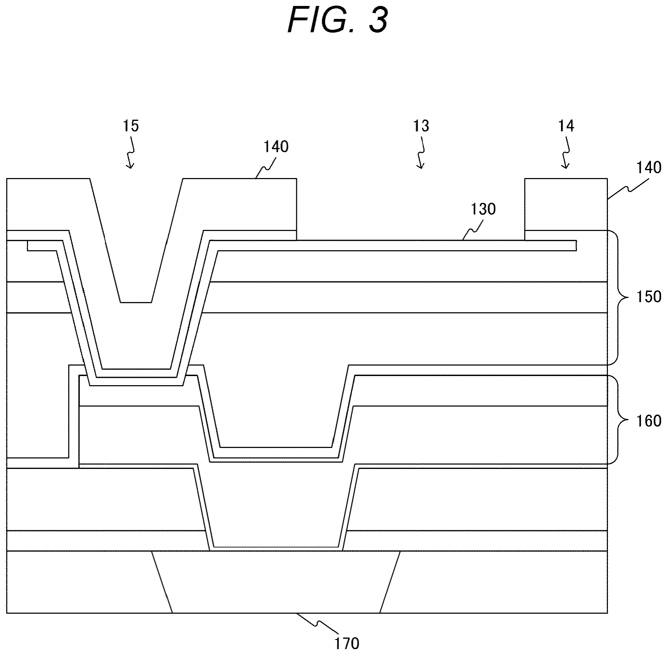

Fig. 3 illustrates an example of a sectional view of the electric charge detection sensor 10 as viewed from above according to the first embodiment of the present technology. Here, a cross-section taken along line A-A' in Fig. 2 is illustrated.

The electric charge detection sensor 10 includes a detection electrode 130 as the detection unit 13. The detection electrode 130 is a water-insoluble electrode using metal such as platinum (Pt) as a material, and a group of conductive nanoparticles each having a size on the order of nanometers is deposited on a surface of the detection electrode 130. It may be assumed that such a group of nanoparticles includes, for example, platinum nanoparticles.

The electric charge detection sensor 10 includes an insulation layer 140 as the insulating portion 14. The insulation layer 140 insulates detection electrodes 130 arranged in an array from each other. As a material of the insulation layer 140, for example, silicon nitride (SiN) or the like can be used. Note that the insulation layer 140 is an example of an insulating portion described in the claims.

An insulation layer 150 is disposed as a layer under the detection electrode 130. As a material of the insulation layer 150, for example, silicon monoxide (SiO), silicon nitride (SiN), or the like can be used.

A wiring layer 160 is disposed as a layer under the insulation layer 150. As a material of the wiring layer 160, for example, titanium nitride (TiN), aluminum copper alloy (AlCu), or the like can be used.

As illustrated, the detection electrode 130 is recessed downward along the recess 15 of the insulation layer 150, where the detection electrode 130 is connected with the wiring layer 160. Note that the recess 15 may be filled with another material or the same material.

An electrode 170 for connection with another layer is disposed under the wiring layer 160. As a material of the electrode 170, for example, copper (Cu), or the like can be used. This allows for connection (Cu-Cu connection) between copper electrodes in different layers.

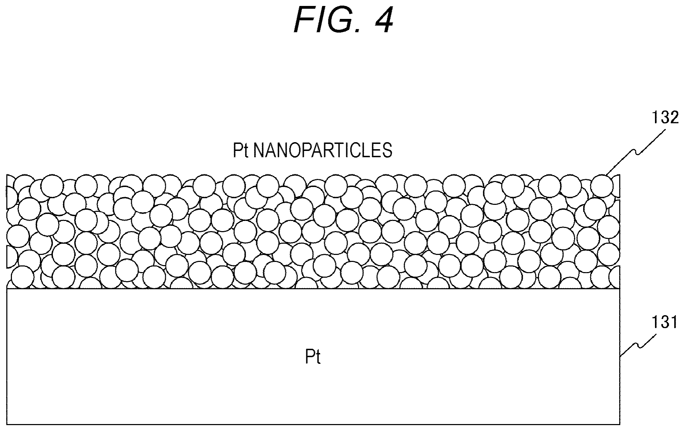

Fig. 4 illustrates an example of a sectional view of the detection electrode 130 according to the embodiment of the present technology.

As described above, the detection electrode 130 includes an electrode 131 that uses metal as a material, with a group of conductive nanoparticles 132 deposited on a surface of the electrode 131. The group of nanoparticles 132 is three-dimensionally deposited as illustrated. This allows for, as compared to a case where only the planar electrode 131 is included, an increase in surface area and a reduction in resistance of the detection electrode 130.

It may be assumed that the group of nanoparticles 132 is deposited by skin coating, that is, spraying the electrode 131 with nanoparticles. The deposition may also be performed by using a technique such as vapor-deposited film forming or sputtering. Note that the group of nanoparticles 132 is an example of a group of particles described in the claims.

### [Shape of insulation layer]

The embodiment has been described above on the assumption that the insulation layer 140 in the insulating portion 14 has vertical side walls. Alternatively, various shapes can be applied as a shape of the insulation layer 140 as exemplified below.

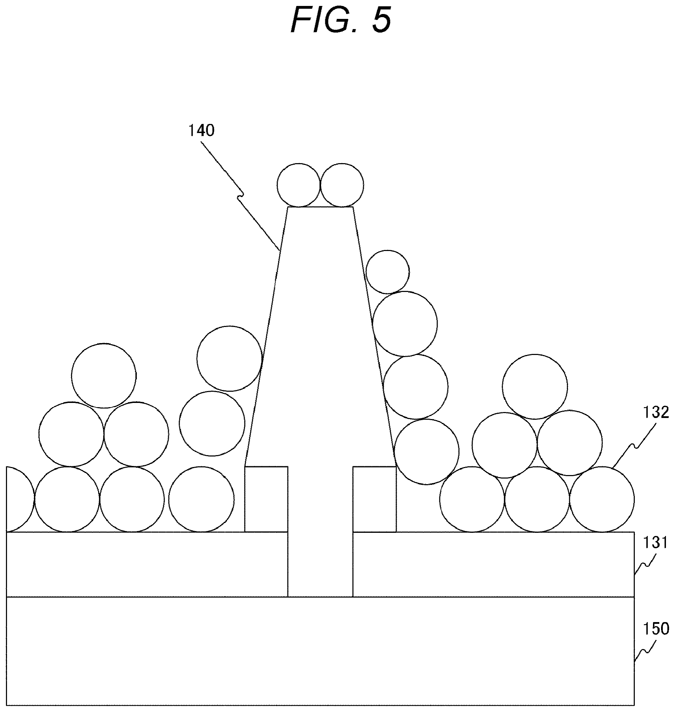

Fig. 5 illustrates a first example of the shape of the insulation layer 140 according to the first embodiment of the present technology. In the first example, the insulation layer 140 has a trapezoidal shape. The insulation layer 140 has side walls that spread downward, and has a planar top.

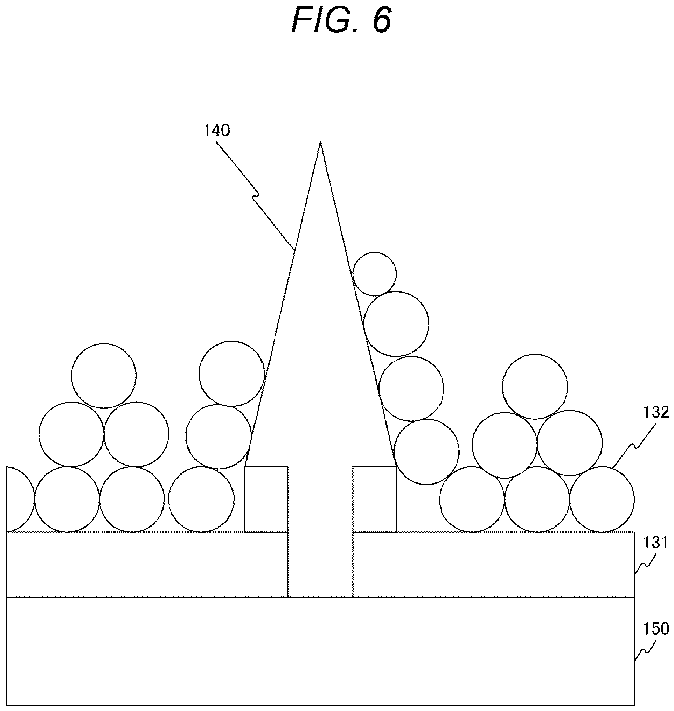

Fig. 6 illustrates a second example of the shape of the insulation layer 140 according to the first embodiment of the present technology. In the second example, the insulation layer 140 has a triangular shape. The insulation layer 140 has side walls that spread downward, and has a sharp top.

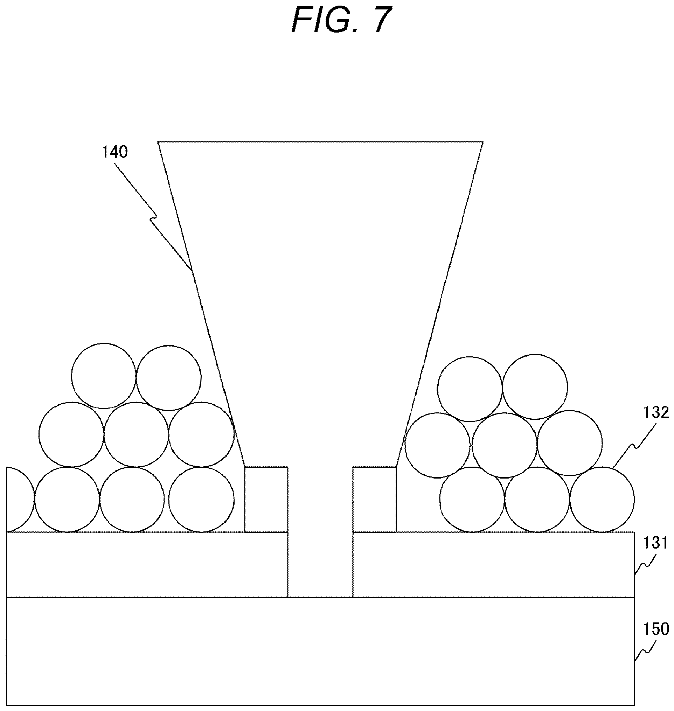

Fig. 7 illustrates a third example of the shape of the insulation layer 140 according to the first embodiment of the present technology. In the third example, the insulation layer 140 has a reverse taper shape. The insulation layer 140 has side walls that spread upward, and has a planar top.

In this way, according to the first embodiment of the present technology, the group of nanoparticles 132 is three-dimensionally deposited on the surface of the detection electrode 130 in the electric charge detection sensor. This increases the surface area and reduces the resistance, thereby improving the sensing sensitivity.

### [Modified example]

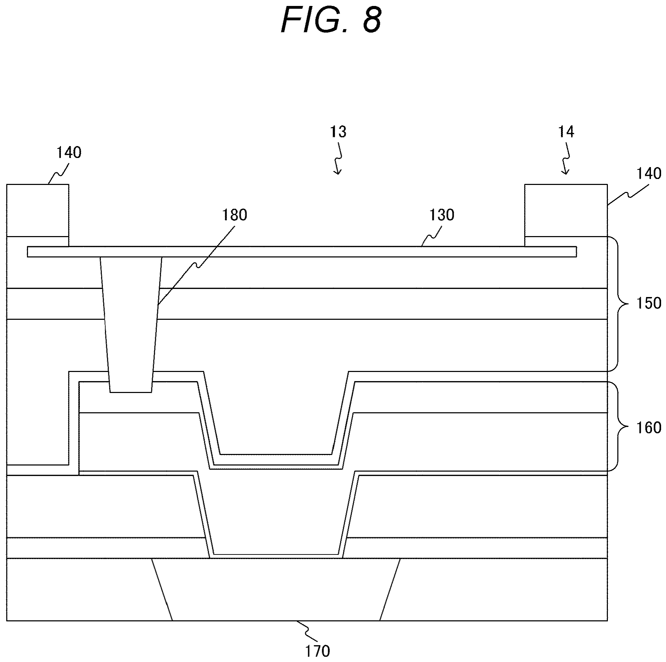

Fig. 8 illustrates an example of a sectional view of an electric charge detection sensor 10 according to a modified example of the first embodiment of the present technology.

In this modified example, a plug-type contact 180 in which an insulating film and a conductor such as metal are embedded in a through hole penetrating the insulation layer 150 is disposed to connect the detection electrode 130 with the wiring layer 160. In this case, it may be assumed that a material of the metal is, for example, tungsten (W) or the like.

Note that the contact 180 may be a through-silicon via (TSV)-type contact in which a conductor such as metal is attached to the bottom and side walls of the hole.

According to this modified example, the detection electrode 130 can be formed into a planar shape, unlike the above-described first embodiment. Furthermore, the contact 180 can be disposed under the detection electrode 130, and this allows for an increase in area of the detection unit 13 (the area where the detection electrode 130 is exposed) and a further improvement in sensing sensitivity.

### <2. Second embodiment>

In the above-described first embodiment, the group of nanoparticles 132 is three-dimensionally deposited on the surface of the detection electrode 130 to increase the surface area. In this case, a conductive film is formed on the side walls of the insulation layer 140, and electric conduction is generated between adjacent detection electrodes 130 and may hinder normal operation. For this reason, in this second embodiment, insulation is provided to prevent continuous covering formed by deposition. Note that an overall configuration of an electric charge detection sensor 10 is similar to that of the above-described first embodiment, and thus detailed description thereof is omitted.

### [Structure]

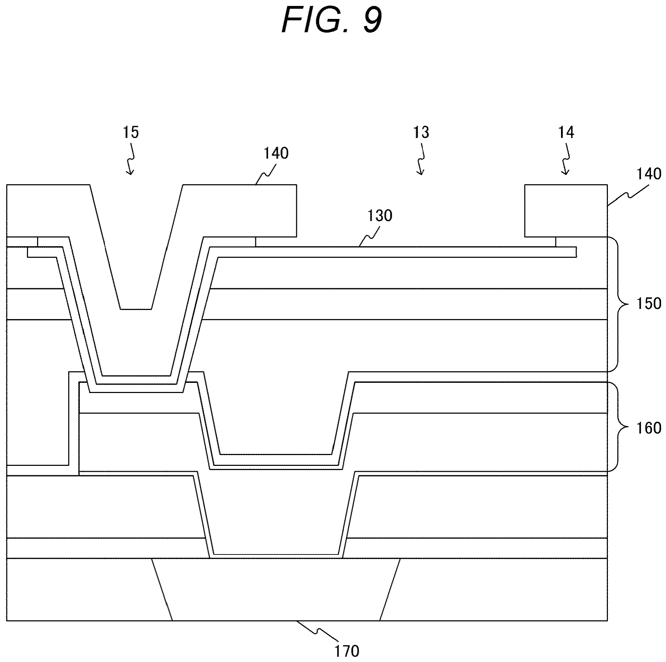

Fig. 9 illustrates an example of a sectional view of the electric charge detection sensor 10 according to the second embodiment of the present technology. Here, a cross-section taken along line A-A' in Fig. 2 is illustrated.

In the second embodiment, an insulation layer 140 has eaves-shaped side walls. That is, the insulation layer 140 has a protruding shape at a portion away from the surface of a detection electrode 130 by a predetermined distance. This prevents continuous formation of a conductive film between detection electrodes 130.

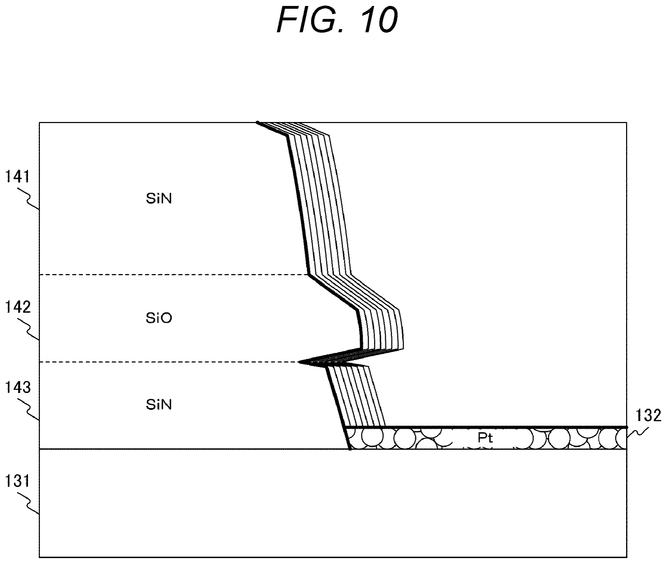

Fig. 10 illustrates an example of a cross-sectional shape of a side wall portion of the insulation layer 140 according to the second embodiment of the present technology.

In this example, the insulation layer 140 includes three layers: a first layer 141, a second layer 142, and a third layer 143. The first layer 141 uses silicon nitride (SiN) as a material. The second layer 142 is a layer that forms a protruding shape, and uses silicon monoxide (SiO) as a material. The third layer 143 uses silicon nitride (SiN) as a material. The reason for using different materials like this is to facilitate formation of an eaves shape on the side walls of the insulation layer 140. Note that, the eaves shape can be formed by using the same type of material. Furthermore, the materials exemplified here are examples, and other materials may be used to form the eaves shape.

The protruding shape of the insulation layer 140 is disposed at a position higher than the height of a group of nanoparticles 132. That is, the third layer 143 is formed to have a thickness greater than the thickness of the group of nanoparticles 132. Each particle in the group of nanoparticles 132 has a size on the order of nanometers, and the thickness of the group of nanoparticles 132 formed by three-dimensionally depositing those particles is, for example, on the order of several tens of nanometers. Thus, the thickness of the third layer 143 under the second layer 142 forming the protruding shape is greater than the order of several tens of nanometers. Considering piling up of particles in the group of nanoparticles 132, the thickness of the third layer 143 is preferably about three times the thickness of the group of nanoparticles 132, for example.

Furthermore, the horizontal length of protrusion of the protruding shape of the insulation layer 140 is arranged to be greater than the height of the group of nanoparticles 132. That is, the second layer 142 is formed so as to protrude beyond the third layer 143 by a length greater than the thickness of the group of nanoparticles 132.

Forming the protruding shape having an appropriate height and length in the insulation layer 140 like this can prevent electric conduction between adjacent detection electrodes 130 caused by continuous covering formed by deposition of the group of nanoparticles 132.

### [Shape of insulation layer]

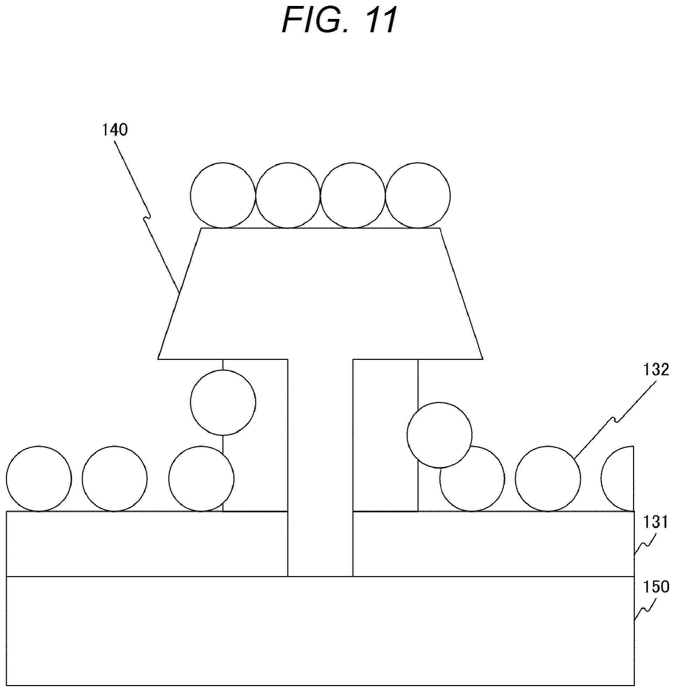

Fig. 11 illustrates an example of a shape of the insulation layer 140 according to the second embodiment of the present technology.

In this example, the insulation layer 140 has a trapezoidal shape and has eaves-shaped side walls. That is, since the insulation layer 140 has eaves-shaped side walls, nanoparticles sprayed for deposition of the group of nanoparticles 132 are prevented from continuously covering over insulation layers 140.

In this way, according to the second embodiment of the present technology, the insulation layer 140 having the eaves-shaped side walls prevents the deposited group of nanoparticles 132 from continuously covering over the insulation layers 140.

### [Modified example]

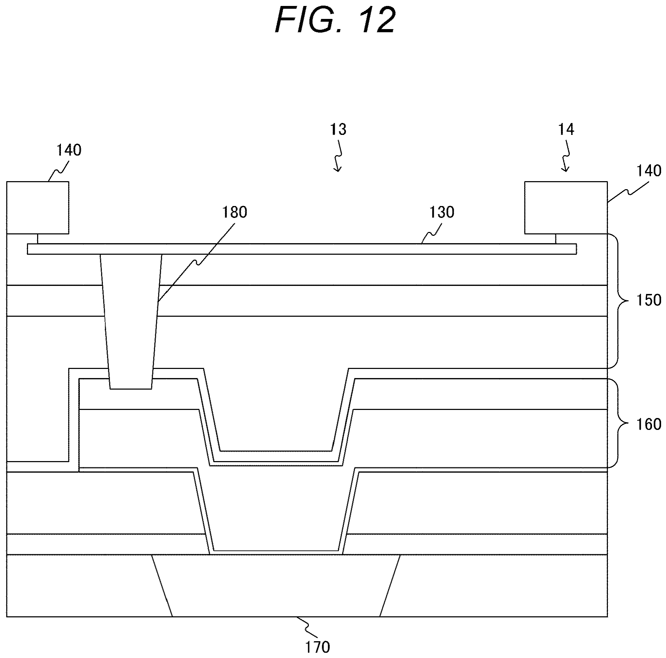

Fig. 12 illustrates an example of a sectional view of the electric charge detection sensor 10 according to a modified example of the second embodiment of the present technology.

In this modified example, as in the above-described first embodiment, a plug-type contact 180 in which an insulating film and a conductor such as metal are embedded in a through hole penetrating an insulation layer 150 is disposed to connect the detection electrode 130 with a wiring layer 160. In this case, it may be assumed that a material of the metal is, for example, tungsten (W). Furthermore, the contact 180 may be a through-silicon via (TSV)-type contact in which a conductor such as metal is attached to the bottom and side walls of the hole.

This modified example of the second embodiment has effects similar to those of the above-described modified example of the first embodiment, thereby further improving the sensing sensitivity.

### <3. Third embodiment>

As described in the above-described embodiments, an electric charge detection sensor 10 can detect electric charge in solution. In this third embodiment, an example of a case in which the electric charge detection sensor 10 is applied to a potential measurement system will be described.

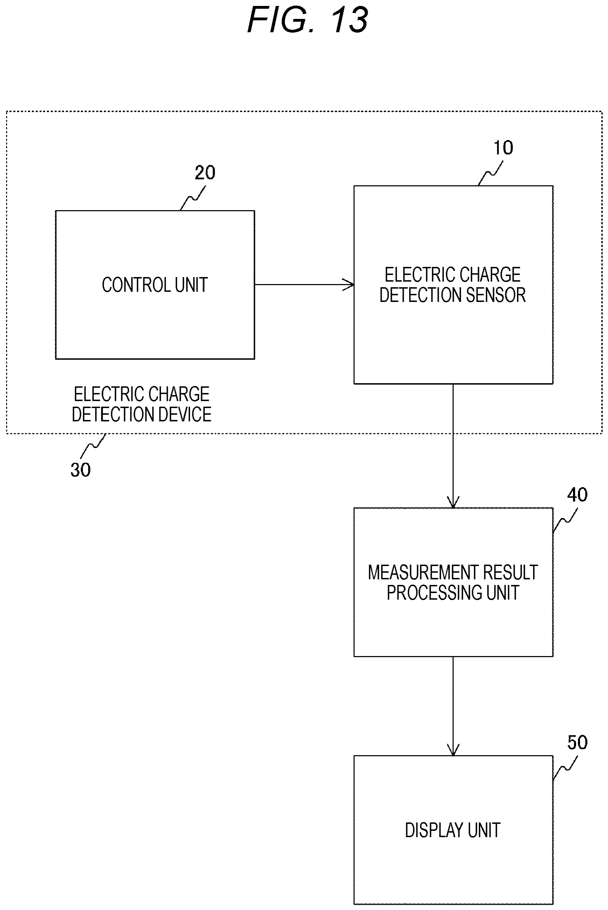

Fig. 13 illustrates a configuration example of the potential measurement system according to the third embodiment of the present technology. This potential measurement system includes, in addition to the electric charge detection sensor 10 described in the above-described embodiments, a control unit 20, a measurement result processing unit 40, and a display unit 50.

In the electric charge detection sensor 10, each of a plurality of cells 12 detects electric charge as described above. This allows for measurement of ions in the solution. This also allows for measurement of a biological activity or identification of a biological substance, thereby allowing the electric charge detection sensor 10 to function as a biosensor.

The control unit 20 drives or controls the electric charge detection sensor 10. For example, the control unit 20 instructs the electric charge detection sensor 10 to start and end potential measurement, or controls choosing of a measurement target or the like.

The measurement result processing unit 40 processes a result of measurement by the electric charge detection sensor 10 on the basis of a preset standard. For example, the measurement result processing unit 40 performs processing such as conversion of measurement data or multiple-level categorization of a numerical value in the measurement data in order to display the measurement result.

The display unit 50 displays the measurement result processed by the measurement result processing unit 40. For example, the display unit 50 shows the measurement result as colors and shades of pixels, two-dimensionally arranges the pixels in a similar manner to an element array, and displays the pixels as an image showing a distribution of electric charges or potentials. Furthermore, for example, images obtained in such a manner can be chronologically displayed to display the images as a moving image showing a change in electric charge or potential.

In this example, the electric charge detection sensor 10 and the control unit 20 constitute an electric charge detection device 30. For example, the electric charge detection device 30 may be installed at a measurement target and store measurement results, and then the stored measurement results may be processed by the measurement result processing unit 40. Furthermore, the electric charge detection device 30 may have a network function so that results of measurement by the electric charge detection sensor 10 may be remotely transmitted in real time and processed by the measurement result processing unit 40 located away from the electric charge detection device 30.

In this way, according to the third embodiment of the present technology, the electric charge detection sensor 10 described in the above-described embodiments can be used to perform measurement and display measurement results on the display unit 50.

Note that the above-described embodiments show examples for embodying the present technology, and the matters in the embodiments correspond to the matters specifying the invention in the claims. Similarly, the matters specifying the invention in the claims correspond to the matters in the embodiments of the present technology having the same names. However, the present technology is not limited to the embodiments, and can be embodied by making a wide variety of modifications to the embodiments without departing from the gist thereof.

Furthermore, the processing procedures described in the above-described embodiments may be regarded as a method including a series of these procedures, or may be regarded as a program for causing a computer to execute the series of these procedures or a recording medium that stores the program. As the recording medium, for example, a compact disc (CD), a MiniDisc (MD), a digital versatile disc (DVD), a memory card, a Blu-ray (registered trademark) disc, or the like can be used.

Note that effects described herein are merely illustrative and are not intended to be restrictive, and other effects may be obtained.

Note that the present technology can also be configured as described below.
(1) An electric charge detection sensor including:
   a plurality of detection electrodes that is arranged in an array and detects electric charge;
   an insulating portion that insulates the plurality of detection electrodes from each other; and
   a group of conductive particles deposited on surfaces of the plurality of detection electrodes.
(2) The electric charge detection sensor according to (1), in which
   the group of particles is a group of nanoparticles each having a size on the order of nanometers.
(3) The electric charge detection sensor according to (2), in which
   the group of particles is a group of platinum nanoparticles.
(4) The electric charge detection sensor according to any one of (1) to (3), in which
   the plurality of detection electrodes is water-insoluble electrodes using metal as a material.
(5) The electric charge detection sensor according to (4), in which
   the plurality of detection electrodes is electrodes using platinum as a material.
(6) The electric charge detection sensor according to any one of (1) to (5), in which
   the insulating portion has a protruding shape at a portion away from a surface of each detection electrode by a predetermined distance.
(7) The electric charge detection sensor according to (6), in which
   the protruding shape of the insulating portion is disposed at a position higher than the height of the group of particles.
(8) The electric charge detection sensor according to (6) or (7), in which
   the protruding shape of the insulating portion has a protrusion longer than the height of the group of particles.
(9) The electric charge detection sensor according to any one of (6) to (8), in which
   the protruding shape of the insulating portion is formed by using a material different from a material of other portions of the insulating portion.
(10) The electric charge detection sensor according to any one of (1) to (9), in which
   each of the plurality of detection electrodes has a recess for connection with a wiring layer.
(11) The electric charge detection sensor according to any one of (1) to (10), further including a contact for connecting each of the plurality of detection electrodes to a wiring layer.
(12) The electric charge detection sensor according to (11), in which
   the contact is a metal-embedded plug-type contact.
(13) The electric charge detection sensor according to (11), in which
   the contact is a through silicon via type contact.
(14) The electric charge detection sensor according to any one of (1) to (13), in which the electric charge detection sensor detects ions in solution that is in contact with each detection electrode.
(15) The electric charge detection sensor according to any one of (1) to (14), in which the electric charge detection sensor includes a biosensor that detects the electric charge to measure a biological activity or identify a biological substance.
(16) A potential measurement system including:
   an electric charge detection sensor that includes a plurality of detection electrodes that is arranged in an array and detects electric charge, an insulating portion that insulates the plurality of detection electrodes from each other, and a group of conductive particles deposited on surfaces of the plurality of detection electrodes, and performs potential measurement;
   a control unit that controls potential measurement in the electric charge detection sensor;
   a measurement result processing unit that processes a result of measurement by the electric charge detection sensor; and
   a display unit that displays the processed measurement result.

### REFERENCE SIGNS LIST

- 10: Electric charge detection sensor
- 11: Detection area
- 12: Cell
- 13: Detection unit
- 14: Insulating portion
- 15: Recess
- 16: Column selection unit
- 17: Row selection unit
- 18: Amplification unit
- 19: A/D conversion unit
- 20: Control unit
- 30: Electric charge detection device
- 40: Measurement result processing unit
- 50: Display unit
- 130: Detection electrode
- 131: Electrode
- 132: Group of nanoparticles
- 140 to 143, 150: Insulation layer
- 160: Wiring layer
- 170: Electrode
- 180: Contact

## Claims

1. An electric charge detection sensor comprising:
a plurality of detection electrodes that is arranged in an array and detects electric charge;
an insulating portion that insulates the plurality of detection electrodes from each other; and
a group of conductive particles deposited on surfaces of the plurality of detection electrodes.

2. The electric charge detection sensor according to claim 1, wherein
the group of particles is a group of nanoparticles each having a size on order of nanometers.

3. The electric charge detection sensor according to claim 2, wherein
the group of particles is a group of platinum nanoparticles.

4. The electric charge detection sensor according to claim 1, wherein
the plurality of detection electrodes is water-insoluble electrodes using metal as a material.

5. The electric charge detection sensor according to claim 4, wherein
the plurality of detection electrodes is electrodes using platinum as a material.

6. The electric charge detection sensor according to claim 1, wherein
the insulating portion has a protruding shape at a portion away from a surface of each detection electrode by a predetermined distance.

7. The electric charge detection sensor according to claim 6, wherein
the protruding shape of the insulating portion is disposed at a position higher than a height of the group of particles.

8. The electric charge detection sensor according to claim 6, wherein
the protruding shape of the insulating portion has a protrusion longer than a height of the group of particles.

9. The electric charge detection sensor according to claim 6, wherein
the protruding shape of the insulating portion is formed by using a material different from a material of other portions of the insulating portion.

10. The electric charge detection sensor according to claim 1, wherein
each of the plurality of detection electrodes has a recess for connection with a wiring layer.

11. The electric charge detection sensor according to claim 1, further comprising a contact for connecting each of the plurality of detection electrodes to a wiring layer.

12. The electric charge detection sensor according to claim 11, wherein
the contact is a metal-embedded plug-type contact.

13. The electric charge detection sensor according to claim 11, wherein
the contact is a through silicon via type contact.

14. The electric charge detection sensor according to claim 1, wherein the electric charge detection sensor detects ions in solution that is in contact with each detection electrode.

15. The electric charge detection sensor according to claim 1, wherein the electric charge detection sensor comprises a biosensor that detects the electric charge to measure a biological activity or identify a biological substance.

16. A potential measurement system comprising:
an electric charge detection sensor that includes a plurality of detection electrodes that is arranged in an array and detects electric charge, an insulating portion that insulates the plurality of detection electrodes from each other, and a group of conductive particles deposited on surfaces of the plurality of detection electrodes, and performs potential measurement;
a control unit that controls potential measurement in the electric charge detection sensor;
a measurement result processing unit that processes a result of measurement by the electric charge detection sensor; and
a display unit that displays the processed measurement result.
